# EUROPEAN PATENT SPECIFICATION

(11) **EP 3 798 644 B1**
(45) Date of publication and mention of the grant of the patent: **13.12.2023**
(21) Application number: 20198033.1
(22) Date of filing: 24.09.2020
(51) Int. Cl.: G01R 19/00, G01R 31/385, G01R 31/396, G01R 31/388

(54) **VOLTAGE SAMPLING CIRCUIT AND METHOD FOR SAMPLING VOLTAGE**
SPANNUNGSABTASTSCHALTUNG UND VERFAHREN ZUR SPANNUNGSABTASTUNG
CIRCUIT D'ÉCHANTILLONNAGE DE TENSION ET PROCÉDÉ D'ÉCHANTILLONNAGE DE TENSION

(30) Priority: 24.09.2019 CN 201910903444
(43) Date of publication of application: 31.03.2021
(73) Proprietor: Globe (Jiangsu) Co., Ltd., Zhonglou District Changzhou, Jiangsu 213023 (CN)
(72) Inventor: WANG, Huage, Changzhou, Jiangsu 213023 (CN); LI, Baoan, Changzhou, Jiangsu 213023 (CN); LIU, Chuanjun, Changzhou, Jiangsu 213023 (CN); ZHUANG, Xian, Changzhou, Jiangsu 213023 (CN)
(74) Representative: Bergenstråhle & Partners AB

(56) References cited:
- CN-A- 102 114 788
- CN-A- 110 146 824
- CN-A- 110 148 987
- US-A1- 2005 116 686
- US-A1- 2011 121 837

## Description

### Technical field

The present invention relates to a voltage sampling circuit and a method for sampling voltage, which belongs to a field of battery management.

### Background art

Usually, in order to expand the versatility of the battery pack, it employs two sets of battery cells connected in series or in parallel to form a dual-voltage battery pack (the rated voltage of every set of cells is N) to provide two different voltages for power tools. When the two sets of cells are connected in parallel, the output voltage is a low voltage N; when the two sets of cells are connected in series, the output voltage is a high voltage 2N.

Because the battery pack needs to provide different voltages to power the electric power tool, two Analog Front-Ends, AFEs, are needed to manage the two sets of cells separately. Usually an AFE with an Analog-to-Digital Converter, ADC, module is much more expensive than an AFE with no ADC. But when the AFE has no ADC module, the high voltage cannot be detected.

CN 110 146 824 discloses a battery charge discharge information system for one set of battery cells connected in series. The system comprises an AFE having an internal ADC.

Hence, there is a need to improve the conventional voltage sampling circuit and the method for sampling the voltage to resolve the above problems.

### Summary of invention

The present invention provides a voltage sampling circuit, the voltage sampling circuit can sample the voltage of at least two sets of cells, the sampling circuit has at least two AFEs ends having, but no ADC module. Therefor the cost of the circuit is reduced.

In order achieve above-mentioned objectives, the present invention provides a voltage sampling circuit for sampling the voltage of at least two sets of cells in a battery pack, the voltage sampling circuit comprises: at least AFE comprising a low-side AFE connected to a first set of cells and a high-side AFE connected to a second set of cells, a subtractor for obtaining the analog voltage of the second set of cells is connected to the high-side AFE with respect to ground comprising: a positive input terminal connecting to an output of the high-side AFE front end for receiving the analog voltage output by the high-side AFE, and a negative input terminal, which when the first set of cells is connected with the second set of cells in series is connected to the total positive voltage of the first set of cells, and which when the first set of cells is connected with the second set of cells in parallel is grounded.

In one embodiment, the voltage sampling circuit comprises a switch control circuit, the switch control circuit comprises a first switch connecting the total positive voltage of the first set of cells with the negative input terminal of the subtractor when the first set of cells and the second set of cells are connected in series, and a second switch connecting the negative input terminal of the subtractor with the ground when the first set of cells is connected in parallel with the second set of cells.

In one embodiment, one end of the first switch is connected to the total positive voltage of the first set of cells and the other end of the first switch is connected to the negative input terminal of the subtractor, one end of the second switch is connected to the negative input terminal of the subtractor and the other end of the second switch is connected to grounded, the first switch is closed and the second switch is open when the first set of cells and the second set of cells are connected in series, the first switch is open and the second switch is closed when the first set of cells and the second set of cells are connected in parallel.

In one embodiment, the voltage sampling circuit further comprises an MCU connected to the output of the low-side AFE and the output of the subtractor, respectively, to receive an sampled analog voltage, wherein the first switch and the second switch are controlled by the MCU based on if the first set of cells and the second set of cells are connected in series or in parallel.

In one embodiment, the voltage sampling circuit further comprises a communication isolation circuit connecting a communication interface of the high-side AFE end to a communication interface of the MCU, wherein the communication isolation circuit communicates with the MCU through a second communication channel.

In one embodiment, the low-side AFE communicates with the MCU through a first communication channel.

In one embodiment, the voltage sample circuit comprises a total voltage sampling circuit, the total voltage sampling circuit is used for sampling the total voltage of at least two sets of cells in the battery pack, so as to determine whether the at least two sets of cells are connected in series or in parallel based on the sampling total voltage.

In one embodiment, at least three control switches are arranged between the first set of cells and the second set of cells to control if the first set of cells and the second set of cells are connected in series or in parallel.

In order achieve above-mentioned objectives, the present invention also provides a method for sampling the voltage of at least two sets of cells in a battery pack, the method comprising the steps: providing at least two analog front ends, AFEs, defined as a low-side AFE and a high-side AFE; connecting the low-side AFE to a first set of cells and the high-side AFE to a second set of cells; providing a subtractor comprising a positive input terminal and a negative input terminal; connecting the positive input terminal of the subtractor to an output interface of the high-side AFE for receiving the analog voltage output by the high-side AFE with respect to ground; and when the first set of cells is connected to the second set of cells in series, connecting the negative input terminal of the subtractor to the total positive voltage of the first set of cells; when the first set of cells is connected to the second set of cells in parallel, connecting the negative input terminal of the subtractor to ground.

In one embodiment, the method further comprises the steps of: sampling the total voltage of at least two sets of cells in the battery pack; and determining whether the at least two sets of cells are connected in series or in parallel based on the sampled total voltage.

The above general description and the following detailed description are intended to be illustrative and not restrictive.

### Brief description of drawings

FIG. 1 is a schematic diagram showing a voltage sampling circuit according to a first embodiment of the present invention.
FIG. 2 is an internal circuit diagram of a subtractor shown in FIG. 1.
FIG. 3 is a flowchart of a method applying the voltage sampling circuit shown in FIG. 1.
FIG. 4 is a schematic diagram showing the voltage sampling circuit in FIG. 1 which is used with three groups of AFEs and three sets of cells.
FIG. 5 is a schematic structural diagram showing a voltage sampling circuit according to a second embodiment of the present invention.

### Detailed description of embodiments

Exemplary embodiments will be described in detail herein, and the embodiments are illustrated in the accompanying drawings. When the following description refers to the drawings, unless otherwise indicated, the same numbers in different drawings indicate the same or similar elements. The exemplary embodiments described hereinafter do not represent all embodiments consistent with present invention. On the contrary, they are only examples of devices, systems, machines and methods consistent with some aspects of the invention as detailed in the appended claims.

In the current battery pack industry, in order to expand the versatility of the battery pack, it usually employs two sets of battery cells, which are connected in series or in parallel to provide two different voltages for power tools, among which the more common ones are a 20V/40V battery pack, a 24V/48V battery pack, and a 40V/80V battery pack. Commonly, the two sets of cells are usually managed by two AFEs, respectively.

The communication can be achieved by directly connecting communication interfaces of an AFE (hereinafter referred to as the low-side AFE) and a MicroController Unit, MCU without setting an isolation chip there in between. The low-side AFE shares the common-ground with the MCU. But another AFE (hereinafter referred to as the high-side AFE) needs to add a communication isolation chip between the high-side AFE and the MCU to communicate with the MCU. Nevertheless, the AFE has an ADC module, which directly can convert the sampled cell voltage into a digital quantity and send it to the MCU for processing through the communication interface. However, some AFEs do not integrate with the ADC module and can only send the analog quantity of corresponding cells to the MCU for sampling. At the same time, the analog quantity of the low-side AFE can be sent directly to the MCU for processing, and the analog quantity of the high-side AFE cannot be directly sent to the MCU, since the MCU will be damaged due to high voltage.

Commonly, the cost of an AFE that integrates the ADC module inside is higher than the cost of an AFE that does not integrate the ADC module inside. In order to reduce costs, it is common to employ the AFE without integrating the ADC module inside, but the problem needs to be resolved when the MCU samples the analog quantity from the high-side AFE.

In order to solve the above described problem, the present invention provides a voltage sampling circuit adapted for sampling the voltages from the at least two sets of cells in the battery pack. For convenience and clarity of the description, the following will take two sets of cells as an example for the detailed description, but it should not be limited thereto.

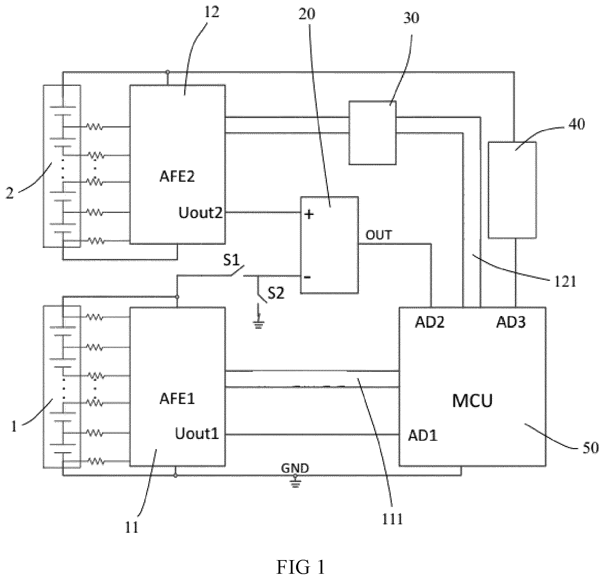

Referring to FIG. 1, the voltage sampling circuit comprises: an AFE, a subtractor 20, a communication isolation circuit 30, a switch control circuit, a total voltage sampling circuit 40 and an MCU 50.

The two sets of cells are defined respectively as a first set of cells 1 and a second set of cells 2, and a control switch is arranged between the first set of cells 1 and the second set of cells 2. The control switch is used to control the first set of cells 1 and the second set of cells 2 in series connection or in parallel connection. Preferably, in the present embodiment, the control switch is a mechanical switch.

The AFE comprises a low-side AFE 11 connected to the first set of cells 1 through a first communication channel 111 and a high-side AFE 12 connected to the second set of cells 2 through a second communication channel 121. The low-side AFE 11 is used to sample the analog voltage from the first set of cells 1 with respect to ground and transmit the analog voltage to the MCU 50. The high-side AFE 12 is used to sample the analog voltage of the second set of cells 2 with respect to ground and transmit it to the MCU 50.

Preferably, as the low-side AFE 11 connects to the MCU 50 through the first communication channel 111, the first communication channel 111 can be used to transmit instructions when the MCU 50 needs to sample the analog voltage relative to ground of any battery cells in the first set of cells 1. After receiving such an instruction, the low-side AFE 11 will quickly detect and extract the analog voltage value of the corresponding cell. In the meanwhile, an interface Uout1 of the low-side AFE 11 is connected to an interface AD1 of the MCU 50, so that after the low-side AFE 11 detects the analog voltage of the corresponding cell, it can be directly output to the MCU 50.

The communication isolation circuit 30 is connected between the high-side AFE 12 and the MCU 50 and connects the communication interface of the high-side AFE 12 with the communication interface of the MCU 50, thereby realizing the communication between the high-side AFE 12 and the MCU 50. Preferably, the high-side AFE 12, the communication isolation circuit 30 and the MCU 50 communicate through the second communication channel 121.

The subtractor 20 is used to obtain the analog voltage (i.e. the actual voltage) of the second set of cells 2 output by the high-side AFE 12 with respect to ground. Specifically, a positive input terminal of the subtractor 20 is connected to an interface Uout2 of the high-side AFE 12 to receive the voltage output from the high-side AFE 12. A negative input terminal of the subtractor 20 is either connected to the total positive voltage of the first set of cells 1 or connected to ground. An output terminal OUT of the subtractor 20 is connected to the interface AD2 of the MCU 50, to transmit the analog voltage (i.e. actual voltage) of the second set of cells 2, output by the subtractor 20 with respect to ground, to the MCU 50.

The total voltage sampling circuit 40 is connected between the second set of cells 2 and the MCU 50 and is used to sample and transmit the total voltages of the two sets of cells of the battery pack to the MCU 50. The MCU 50 firstly determines the first set of cells 1 and the second set of cells 2 in series connection or in parallel connection based on the received total voltages and then controls the operation of the switch control circuit. As can be understood, in other embodiments, the total voltage sampling circuit 40 may not be employed, and the first set of cells 1 and the second set of cells 2 can be manually arranged in series connection or in parallel connection, as long as the connection relationship between the first set of cells 1 and the second set of cells 2 can be determined.

The switch control circuit comprises a first switch S1 and a second switch S2. The first switch S1 connects the total positive voltage of the first set of cells 1 with the subtractor 20, when the first set of cells 1 and the second set of cells 2 are in series connection. The second switch S2 connects the subtractor 20 with ground (i.e. grounding the subtractor 20), when the first set of cells 1 and the second set of cells 2 are in parallel connection. Specifically, one end of the first switch S1 is connected to the total positive voltage of the first set of cells 1, the other end is connected to the negative input terminal of the subtractor 20, and one end of the second switch S2 is connected to the negative input terminal of the subtractor 20 and the other end is grounded. When the first set of cells 1 and the second set of cells 2 are connected in series, the first switch S1 is closed and the second switch S2 is opened, and the positive input terminal of the subtractor 20 inputs the voltage output by the high-side AFE 12 and the negative input terminal inputs the voltages of the first set of cells 1. At this time, the output terminal OUT of the subtractor 20 outputs the analog voltage of the second set of cells 2 relative to ground, that is, the actual voltage; when the first set of cells 1 and the second set of cells 2 are connected in parallel, the first switch S1 is opened and the second switch S2 is closed, and the positive input terminal of the subtractor 20 inputs the voltage output by the high-side AFE and the negative input terminal is grounded. At this time, the output terminal OUT of the subtractor 20 also outputs the analog voltage of the second set of cells 2 relative to ground, that is, the actual voltage.

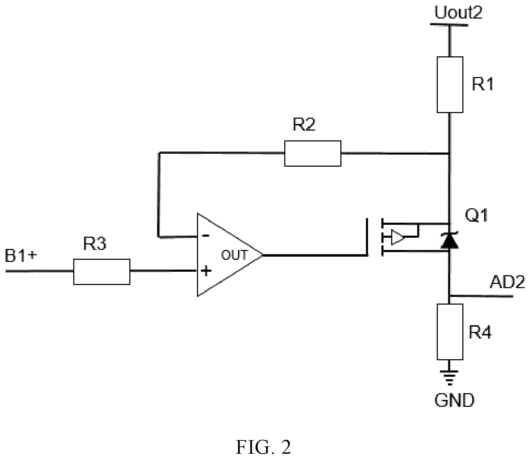

Referring to FIG. 2, when the first set of cells 1 and the second set of cells 2 are connected in series and the high-side AFE 12 is referenced to ground (GND), the output value of the interface Uout2 is the voltage value when the reference is GND, therefore, by subtracting the total voltage of the first set of cells 1 from the voltage output by the high-side AFE 12, the actual voltage of the detected second group of cells 2 can be obtained. When taking GND as a reference, the output voltage value of the interface Uout2 is relatively high. If directly inputting the voltage into the MCU 50, it will damage the MCU 50 (beyond the allowable range of the MCU), so that the subtractor 20 is used to subtract the total voltage of the first set of cells 1, and the actual voltage of the detected second set of cells 2 can be obtained. The value is small and can be input to the MCU 50.

It should be noted that in the case of series connection, taking GND as a reference, the voltage value output by the low-side AFE 11 is the actual voltage value of the detected first set of cells 1, while the voltage value output by the high-side AFE 12 is the value superimposing the actual voltage value of the detected second set of cells 2 on the voltage of the first set of cells 1. Therefore, in order to get the real detected voltage value of the second set of cells 2, it needs to subtract the total voltage of the first set of cells 1 through the subtractor 20.

In the case of the parallel connection between the first set of cells 1 and the second set of cells 2, the voltage output by the high-side AFE 12 is the real voltage value of the second set of cells 2, so when grounding the negative input terminal of the subtractor 20, the actual voltage of the second set of cells 2 can be directly obtained. The value is small and can be directly input to the MCU 50.

Opening or closing of the first switch S 1 and the second switch S2 is controlled by the MCU 50. That is, if determining that the first set of cells 1 and the second set of cells 2 are connected in series, the MCU 50 controls the first switch S 1 to close and the second switch S2 to open; if determining that the first set of cells 1 and the second set of cells are connected in parallel, the MCU 50 controls the first switch S 1 to open and the second switch S2 to close.

The method of sampling voltage of the present invention mainly comprises the following steps:
Providing an AFE, and defining a low-side AFE 11 connecting to a first set of cells 1 of the at least two sets of cells and a high-side AFE 12 connecting to a second set of cells 2;
Providing a subtractor 20, and connecting a positive input terminal of the subtractor 20 with an output interface Uout2 of the high-side AFE 12;
Connecting a negative input terminal of the subtractor 20 with the total positive voltage of the first set cells 1 and inputting the voltage by the first set cells 1, when the first set of cells 1 is connected with the second set of cells 2 in series; grounding the negative input terminal of the subtractor 20 when the first set of cells 1 is connected with the second set of cells 2 in parallel.

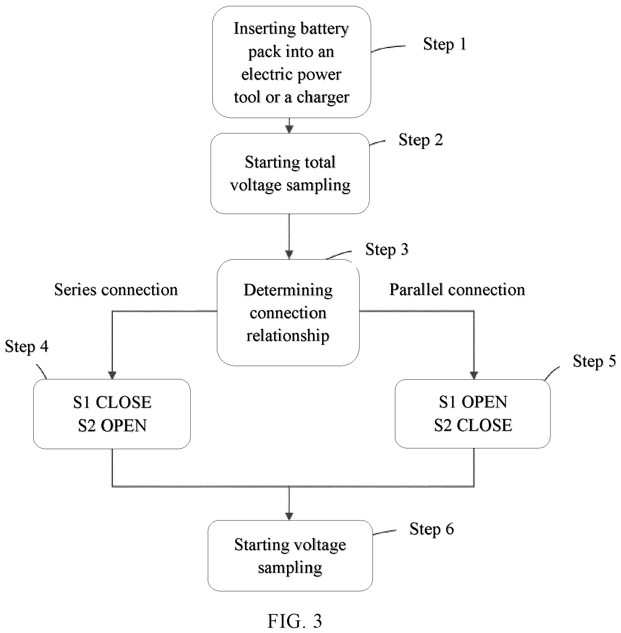

Referring to FIG. 3, the method of sampling voltage specifically comprises the following steps:
Step 1, a battery pack is inserted into an electric power tool or a charger;
Step 2, starting total voltage sampling: after awakening the battery pack, the MCU 50 controls the total voltage sampling circuit 40 to operate, and sampling the total voltage of the two sets of cells in the battery pack through the interface AD3;
Step 3, determining the series relationship or the parallel relationship (i.e. series connection or parallel connection) between the two sets of cells based on the sampled total voltage, if it is the series connection, then jump to Step 4, if it is the parallel connection, then jump to Step 5;
Step 4, the MCU 50 controls the first switch S1 to close and the second switch S2 to open;
Step 5, the MCU 50 controls the first switch S1 to open and the second switch S2 to close;
Step 6, start voltage sampling: the MCU 50 starts the first communication channel 111, and samples the analog voltage (i.e. actual voltage) relative to the ground of the first set of cells 1 through the low-side AFE 11 and the analog voltage is sent to the interface AD1 of the MCU through Vout1 of the low-side AFE 11; at the same time, the MCU 50 starts the second communication channel 121, and samples the analog voltage (i.e. actual voltage) relative to ground of the second set of cells 2 through the high-side AFE 12, the analog voltage of the second set of cells 2 is sent to the interface AD2 of the MCU after being subtracted by the subtractor 20;
Step 7, repeating Step 6 until the voltage of all cells are sampled.

It should be noted that the voltage sampling by the present invention is the actual voltage of each cell (comprising the first set of cells 1 and the second set of cells 2), while not the total voltage of the cell sets.

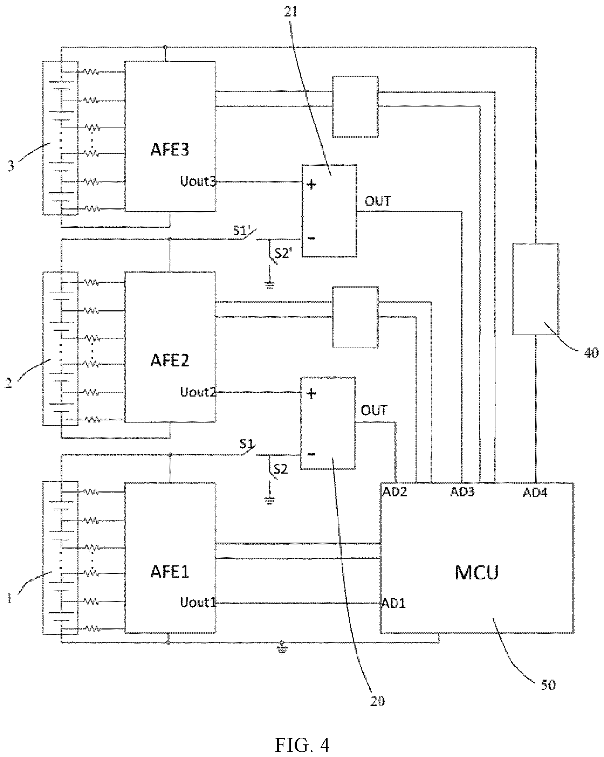

Referring to FIG. 4, the voltage sampling circuit of the present invention is not only applicable for the case of two groups of AFEs, but also applicable for the case of three or more groups of analog AFEs.

When the voltage sampling device of the present invention is applied to three groups of AFEs, the voltage sampling method of the first set of cells 1 and the second set of cells 2 is the same as shown in FIG. 1 - FIG. 3, which will not be described in detail here.

Similarly, as for the third set of cells 3, when the first set of cells 1, the second set of cells 2, the third set of cells 3 are connected to each other in series, the third switch S1' is closed, the second switch S2' is opened/disconnected. At this time, the positive input terminal of a second subtractor 21 inputs the voltage output by the Uout3 of the AFE3, and the negative input terminal inputs the voltages of the first set of cells 1 and the second set of cells 2, and the output terminal OUT of the second subtractor 21 outputs the analog voltage relative to the ground of the third set of cells 2, which is the real voltage subtracting the voltages of the first set of cells 1 and the second set of cells 2. At this time, the first switch S 1 is closed and second switch S2 is opened. When the first set of cells 1, the second set of cells 2 and the third set of cells 3 are connected in parallel, the third switch S1' is off/opened and the second switch S2' is closed, at this time, the positive input terminal of the second subtractor 21 inputs the voltage output by the AFE3, and the negative input terminal is grounded. The output terminal OUT of the second subtractor 21 outputs the analog voltage of the third set of cells 3 relative to ground, which is the actual voltage.

Similarly, when the voltage sampling circuit of the present invention is applied to four sets of AFEs, three subtractors can be used to sample the analog voltage relative to ground of the cells connected to the corresponding high-side AFE, and the analog voltage can be safely transmitted to the MCU 50, which will not be described in detail here.

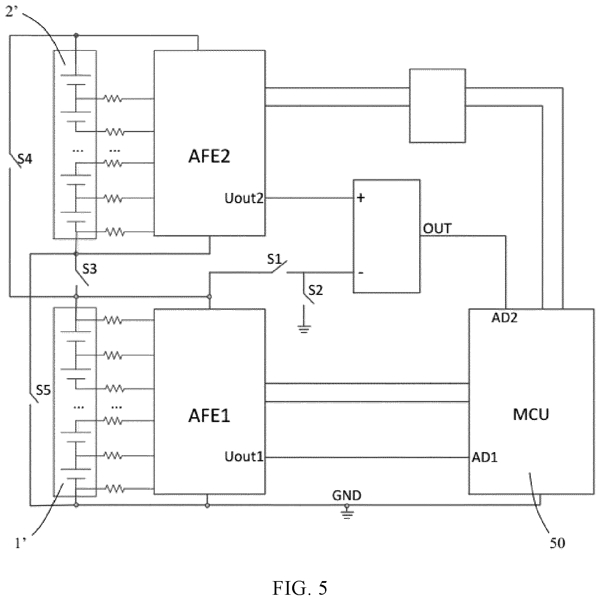

Referring to FIG. 5, a second embodiment of the voltage sampling circuit of the present invention is shown. In this embodiment, the control switch that is arranged between the first set of cells 1' and the second set of cells 2' comprises electronic switches S3, S4, S5, which therefore can be used to control the first set of cells 1' and the second set of cells 2' in series connection or in parallel connection.

Specifically, when the first set of cells 1' and the second set of cells 2' need to be connected in series, the MCU 50 controls the electronic switch S3 to close and the electronic switches S4 and S5 to open, and the analog voltage of the cells in the first set of cells 1' and the second set of cells 2' is sampled. When the first set of cells 1' and the second set of cells 2' are connected in parallel, the MCU 50 controls the electronic switches S4 and S5 to close and the electronic switch S3 to open, and the analog voltage of the cells in the first set of cells 1' and the second set of cells 2' is sampled.

As for the method of voltage sampling from the first set cells 1' and the second set of cells 2', it can be referred to FIGS. 1 to 3, which will not be described in detail here.

As a whole, the present invention firstly determines the series/parallel connections between the two sets of cells based on the total voltage, and then adjusts the input of the negative input terminal of the subtractor 20 by switching the switches S 1 and S2, so that a real voltage of the detected cells can be achieved through the subtractor 20, regardless of whether in series or in a parallel connection. It can be seen that the present invention employs the switches and the subtractor 20 which makes the output terminal of the subtractor 20 output the real voltage input by the high-side AFE 12 connected to the detected cells. No ADC module is needed to be integrated in the AFE, therefore, the cost is reduced.

To summarize, the voltage sampling circuit of the present invention employs the subtractor 20 for subtracting the total voltages of the first set of cells 1 from the voltage output by the high-side AFE 12 when the at least two sets of cells are connected to each other in series, so as to sample the analog voltage of the second set of cells relative to ground. The voltage sampling circuit of the present invention employs the subtractor 20 to ground the negative input terminal of the subtractor 20 to thereby obtain the analog voltage relative to the ground when the at least two sets of cells are connected to each other in parallel, so as to sample the analog voltage of the second set of cells relative to the ground. Hence, the MCU avoids being damaged due to high voltage.

It is to be understood, however, that even though numerous characteristics and advantages of preferred and exemplary embodiments have been set out in the foregoing description, together with details of the structures and functions of the embodiments, the disclosure is illustrative only; and that changes may be made in detail within the scope of present disclosure to the full extent indicated by the broadest general meaning of the terms in which the appended claims are expressed.

## Claims

1. A voltage sampling circuit for sampling the voltage of at least two sets of cells (1, 2) in a battery pack, the voltage sampling circuit comprising:
at least two analog front ends, AFEs (11, 12), comprising a low-side AFE (11) connected to a first set of cells (1) and a high-side AFE (12) connected to a second set of cells (2);
a subtractor (20) for obtaining the analog voltage of the second set of cells (2) connected to the high-side AFE (12) with respect to ground comprising:
a positive input terminal connecting to an output interface (Uout2) of the high-side AFE (12) for receiving the analog voltage output by the high-side AFE (12); and
a negative input terminal, which when the first set of cells (1) is connected with the second set of cells (2) in series is connected to the total positive voltage of the first set of cells (1), and which when the first set of cells (1) is connected with the second set of cells (2) in parallel is grounded.

2. The voltage sampling circuit as claimed in claim 1, further comprising a switch control circuit, the switch control circuit comprises a first switch (S1) connecting the total positive voltage of the first set of cells (1) with the negative input terminal of the subtractor (20) when the first set of cells (1) and the second set of cells (2) are connected in series, and a second switch (S2) connecting the negative input terminal of the subtractor (20) with ground when the first set of cells (1) is connected in parallel with the second set of cells (20).

3. The voltage sampling circuit as claimed in claim 2, wherein one end of the first switch (S1) is connected to the total positive voltage of the first set of cells (1) and the other end of the first switch (S1) is connected to the negative input terminal of the subtractor (20), one end of the second switch (S2) is connected to the negative input terminal of the subtractor (20) and the other end of the second switch (S2) is connected to ground, the first switch (S1) is closed and the second switch (S2) is open when the first set of cells (1) and the second set of cells (2) are connected in series, the first switch (S1) is open and the second switch (S2) is closed when the first set of cells (1) and the second set of cells (2) are connected in parallel.

4. The voltage sampling circuit as claimed in claim 2 or 3, further comprising an MCU (50) connected to the output of the low-side AFE (11) and the output of the subtractor (20), respectively, to receive a sampled analog voltage, wherein the first switch (S1) and the second switch (S2) are controlled by the MCU (50) based on series or parallel connection between the first set of cells (1) and the second set of cells (2).

5. The voltage sampling circuit as claimed in claim 4, further comprising a communication isolation circuit (30) connecting a communication interface of the high-side AFE (12) to a communication interface of the MCU (50), wherein the communication isolation circuit (30) communicates with the MCU (50) through a second communication channel (121).

6. The voltage sampling circuit as claimed in claim 4 or 5, wherein the low-side AFE (11) communicates with the MCU (50) through a first communication channel (111).

7. The voltage sampling circuit as claimed in any one of the preceding claims, further comprising a total voltage sampling circuit (40), the total voltage sampling circuit (40) is used for sampling the total voltage of at least two sets of cells (1, 2) in the battery pack, so as to determine whether the at least two sets of cells are connected in series or in parallel based on the sampled total voltage.

8. The voltage sampling circuit as claimed in any one of the preceding claims, wherein at least three control switches are arranged between the first set of cells (1) and the second set of cells (2) to control if the first set of cells (1) and the second set of cells (2) are connected in series or in parallel.

9. A method for sampling the voltage of at least two sets of cells (1, 2) in a battery pack, the method comprising the steps of:
providing at least two analog front ends, AFEs (11, 12) defined as a low-side AFE (11) and a high-side AFE (12);
connecting the low-side AFE (11) to a first set of cells (1) and the high-side AFE (12) to a second set of cells (2);
providing a subtractor (20) comprising a positive input terminal and a negative input terminal;
connecting the positive input terminal of the subtractor (20) to an output interface (Uout2) of the high-side AFE (12) for receiving the analog voltage output by the high-side AFE (12) with respect to ground; and
when the first set of cells (1) is connected to the second set of cells (2) in series, connecting the negative input terminal of the subtractor (20) to the total positive voltage of the first set of cells (1);
when the first set of cells (1) is connected to the second set of cells (2) in parallel, connecting the negative input terminal of the subtractor (20) to ground.

10. The method for sampling voltage as claimed in claim 9, further comprising the steps of:
sampling the total voltage of at least two sets of cells (1, 2) in the battery pack; and
determining whether the at least two sets of cells (1, 2) are connected in series or in parallel based on the sampled total voltage.

## Patentansprüche

1. Spannungsabtastschaltung zum Abtasten der Spannung von mindestens zwei Sätzen von Zellen (1, 2) in einem Batteriepack, wobei die Spannungsabtastschaltung Folgendes umfasst:
mindestens zwei Analog-Front-Ends, AFEs (11, 12), umfassend ein Low-Side-AFE (11), das mit einem ersten Satz von Zellen (1) verbunden ist, und ein High-Side-AFE (12), das mit einem zweiten Satz von Zellen (2) verbunden ist;
einen Subtrahierer (20) zum Erhalten der Analogspannung des zweiten Satzes von Zellen (2), der mit dem High-Side-AFE (12) verbunden ist, in Bezug auf die Masse, umfassend:
einen positiven Eingangsanschluss, der mit einer Ausgangsschnittstelle (Uout2) des High-Side-AFE (12) verbunden ist, um die von dem High-Side-AFE (12) ausgegebene Analogspannung zu empfangen; und
einen negativen Eingangsanschluss, der, wenn der erste Satz von Zellen (1) mit dem zweiten Satz von Zellen (2) in Reihe geschaltet ist, mit der gesamten positiven Spannung des ersten Satzes von Zellen (1) verbunden ist, und der, wenn der erste Satz von Zellen (1) mit dem zweiten Satz von Zellen (2) parallel geschaltet ist, geerdet ist.

2. Spannungsabtastschaltung nach Anspruch 1, weiter umfassend eine Schaltersteuerschaltung, wobei die Schaltersteuerschaltung einen ersten Schalter (S1) umfasst, der die gesamte positive Spannung des ersten Satzes von Zellen (1) mit dem negativen Eingangsanschluss des Subtrahierers (20) verbindet, wenn der erste Satz von Zellen (1) und der zweite Satz von Zellen (2) in Reihe geschaltet sind, und einen zweiten Schalter (S2), der den negativen Eingangsanschluss des Subtraktors (20) mit Masse verbindet, wenn der erste Satz von Zellen (1) mit dem zweiten Satz von Zellen (20) parallel geschaltet ist.

3. Spannungsabtastschaltung nach Anspruch 2, wobei ein Ende des ersten Schalters (S1) mit der gesamten positiven Spannung des ersten Satzes von Zellen (1) verbunden ist und das andere Ende des ersten Schalters (S1) mit dem negativen Eingangsanschluss des Subtrahierers (20) verbunden ist, ein Ende des zweiten Schalters (S2) mit dem negativen Eingangsanschluss des Subtrahierers (20) verbunden ist und das andere Ende des zweiten Schalters (S2) mit Masse verbunden ist, der erste Schalter (S1) geschlossen ist und der zweite Schalter (S2) offen ist, wenn der erste Satz von Zellen (1) und der zweite Satz von Zellen (2) in Reihe geschaltet sind, der erste Schalter (S1) offen ist und der zweite Schalter (S2) geschlossen ist, wenn der erste Satz von Zellen (1) und der zweite Satz von Zellen (2) parallel geschaltet sind.

4. Spannungsabtastschaltung nach Anspruch 2 oder 3, weiter umfassend eine MCU (50), die mit dem Ausgang des Low-Side-AFE (11) bzw. dem Ausgang des Subtrahierers (20) verbunden ist, um eine abgetastete Analogspannung zu empfangen, wobei der erste Schalter (S1) und der zweite Schalter (S2) von der MCU (50) basierend auf einer Reihen- oder Parallelschaltung zwischen dem ersten Satz von Zellen (1) und dem zweiten Satz von Zellen (2) gesteuert werden.

5. Spannungsabtastschaltung nach Anspruch 4, weiter umfassend eine Kommunikationsisolationsschaltung (30), die eine Kommunikationsschnittstelle des High-Side-AFE (12) mit einer Kommunikationsschnittstelle der MCU (50) verbindet, wobei die Kommunikationsisolationsschaltung (30) mit der MCU (50) über einen zweiten Kommunikationskanal (121) kommuniziert.

6. Spannungsabtastschaltung nach Anspruch 4 oder 5, wobei die Low-Side-AFE (11) mit der MCU (50) über einen ersten Kommunikationskanal (111) kommuniziert.

7. Spannungsabtastschaltung nach einem der vorstehenden Ansprüche, weiter umfassend eine Gesamtspannungsabtastschaltung (40), wobei die Gesamtspannungsabtastschaltung (40) zum Abtasten der Gesamtspannung von mindestens zwei Sätzen von Zellen (1, 2) in dem Batteriepack verwendet wird, um basierend auf der abgetasteten Gesamtspannung zu bestimmen, ob die mindestens zwei Sätze von Zellen in Reihe oder parallel geschaltet sind.

8. Spannungsabtastschaltung nach einem der vorstehenden Ansprüche, wobei mindestens drei Steuerschalter zwischen dem ersten Satz von Zellen (1) und dem zweiten Satz von Zellen (2) angeordnet sind, um zu steuern, ob der erste Satz von Zellen (1) und der zweite Satz von Zellen (2) in Reihe oder parallel geschaltet sind.

9. Verfahren zum Abtasten der Spannung von mindestens zwei Sätzen von Zellen (1, 2) in einem Batteriepack, wobei das Verfahren die folgenden Schritte umfasst
Bereitstellen von mindestens zwei Analog-Front-Ends, AFEs (11, 12), die als ein Low-Side-AFE (11) und ein High-Side-AFE (12) definiert sind;
Verbinden des Low-Side-AFE (11) mit einem ersten Satz von Zellen (1) und des High-Side-AFE (12) mit einem zweiten Satz von Zellen (2);
Bereitstellen eines Subtrahierers (20), der einen positiven Eingangsanschluss und einen negativen Eingangsanschluss umfasst;
Verbinden des positiven Eingangsanschlusses des Subtrahierers (20) mit einer Ausgangsschnittstelle (Uout2) des High-Side-AFE (12) zum Empfangen der von dem High-Side-AFE (12) ausgegebenen Analogspannung in Bezug auf die Masse; und
wenn der erste Satz von Zellen (1) mit dem zweiten Satz von Zellen (2) in Reihe geschaltet ist, Verbinden des negativen Eingangsanschlusses des Subtrahierers (20) mit der gesamten positiven Spannung des ersten Satzes von Zellen (1);
wenn der erste Satz von Zellen (1) mit dem zweiten Satz von Zellen (2) parallel geschaltet ist, Verbinden des negativen Eingangsanschlusses des Subtrahierers (20) mit Masse.

10. Verfahren zur Spannungsabtastung nach Anspruch 9, das weiter die folgenden Schritte umfasst:
Abtasten der Gesamtspannung von mindestens zwei Sätzen von Zellen (1, 2) im Batteriepack; und
Bestimmen, ob die mindestens zwei Sätze von Zellen (1, 2) in Reihe oder parallel geschaltet sind, basierend auf der abgetasteten Gesamtspannung.

## Revendications

1. Circuit d'échantillonnage de tension pour échantillonner la tension d'au moins deux ensembles d'éléments (1, 2) dans un bloc-batterie, le circuit d'échantillonnage de tension comprenant :
au moins deux extrémités frontales analogiques, AFE, (11, 12), comprenant une AFE côté bas (11) connectée à un premier ensemble d'éléments (1) et une AFE côté haut (12) connectée à un second ensemble d'éléments (2) ;
un soustracteur (20) pour obtenir la tension analogique du second ensemble d'éléments (2) connecté à l'AFE côté haut (12) par rapport à la masse, comprenant :
une borne d'entrée positive se connectant à une interface de sortie (Uout2) de l'AFE côté haut (12) pour recevoir la tension analogique délivrée en sortie par l'AFE côté haut (12) ; et
une borne d'entrée négative qui, lorsque le premier ensemble d'éléments (1) est connecté au second ensemble d'éléments (2) en série, est connectée à la tension positive totale du premier ensemble d'éléments (1) et qui, lorsque le premier ensemble d'éléments (1) est connecté au second ensemble d'éléments (2) en parallèle, est mise à la terre.

2. Circuit d'échantillonnage de tension selon la revendication 1, comprenant en outre un circuit de commande de commutateurs, le circuit de commande de commutateurs comprend un premier commutateur (S1) connectant la tension positive totale du premier ensemble d'éléments (1) à la borne d'entrée négative du soustracteur (20) lorsque le premier ensemble d'éléments (1) et le second ensemble d'éléments (2) sont connectés en série, et un deuxième commutateur (S2) connectant la borne d'entrée négative du soustracteur (20) à la masse lorsque le premier ensemble d'éléments (20) est connecté en parallèle au second ensemble d'éléments (20).

3. Circuit d'échantillonnage de tension selon la revendication 2, dans lequel une extrémité du premier commutateur (S1) est connectée à la tension positive totale du premier ensemble d'éléments (1) et l'autre extrémité du premier commutateur (S1) est connectée à la borne d'entrée négative du soustracteur (20), une extrémité du deuxième commutateur (S2) est connectée à la borne d'entrée négative du soustracteur (20) et l'autre extrémité du deuxième commutateur (S2) est connectée à la masse, le premier commutateur (S1) est fermé et le deuxième commutateur (S2) est ouvert lorsque le premier ensemble d'éléments (1) et le second ensemble d'éléments (2) sont connectés en série, le premier commutateur (S1) est ouvert et le deuxième commutateur (S2) est fermé lorsque le premier ensemble d'éléments (1) et le second ensemble d'éléments (2) sont connectés en parallèle.

4. Circuit d'échantillonnage de tension selon la revendication 2 ou 3, comprenant en outre une MCU (50) connectée à la sortie de l'AFE côté bas (11) et à la sortie du soustracteur (20), respectivement, pour recevoir une tension analogique échantillonnée, dans lequel le premier commutateur (S1) et le deuxième commutateur (S2) sont commandés par la MCU (50) sur la base d'une connexion en série ou en parallèle entre le premier ensemble d'éléments (1) et le second ensemble d'éléments (2).

5. Circuit d'échantillonnage de tension selon la revendication 4, comprenant en outre un circuit d'isolation de communication (30) connectant une interface de communication de l'AFE côté haut (12) à une interface de communication de la MCU (50), dans lequel le circuit d'isolation de communication (30) communique avec la MCU (50) via un second canal de communication (121).

6. Circuit d'échantillonnage de tension selon la revendication 4 ou 5, dans lequel l'AFE côté bas (11) communique avec la MCU (50) via un premier canal de communication (111).

7. Circuit d'échantillonnage de tension selon l'une quelconque des revendications précédentes, comprenant en outre un circuit d'échantillonnage de tension totale (40), le circuit d'échantillonnage de tension totale (40) est utilisé pour échantillonner la tension totale d'au moins deux ensembles d'éléments (1, 2) dans le bloc-batterie, de manière à déterminer si les au moins deux ensembles d'éléments sont connectés en série ou en parallèle sur la base de la tension totale échantillonnée.

8. Circuit d'échantillonnage de tension selon l'une quelconque des revendications précédentes, dans lequel au moins trois commutateurs de commande sont disposés entre le premier ensemble d'éléments (1) et le second ensemble d'éléments (2) pour commander si le premier ensemble d'éléments (1) et le second ensemble d'éléments (2) sont connectés en série ou en parallèle.

9. Procédé d'échantillonnage de la tension d'au moins deux ensembles d'éléments (1, 2) dans un bloc-batterie, le procédé comprenant les étapes consistant à :
fournir au moins deux extrémités frontales analogiques, AFE, (11, 12) définies comme une AFE côté bas (11) et une AFE côté haut (12) ;
connecter l'AFE côté bas (11) à un premier ensemble d'éléments (1) et l'AFE côté haut (12) à un second ensemble d'éléments (2) ;
fournir un soustracteur (20) comprenant une borne d'entrée positive et une borne d'entrée négative ;
connecter la borne d'entrée positive du soustracteur (20) à une interface de sortie (Uout2) de l'AFE côté haut (12) pour recevoir la tension analogique délivrée en sortie par l'AFE côté haut (12) par rapport à la masse ; et
lorsque le premier ensemble d'éléments (1) est connecté au second ensemble d'éléments (2) en série, connecter la borne d'entrée négative du soustracteur (20) à la tension positive totale du premier ensemble d'éléments (1) ;
lorsque le premier ensemble d'éléments (1) est connecté au second ensemble d'éléments (2) en parallèle, connecter la borne d'entrée négative du soustracteur (20) à la masse.

10. Procédé d'échantillonnage de tension selon la revendication 9, comprenant en outre les étapes consistant à :
échantillonner la tension totale d'au moins deux ensembles d'éléments (1, 2) dans le bloc-batterie ; et
déterminer si les au moins deux ensembles d'éléments (1, 2) sont connectés en série ou en parallèle sur la base de la tension totale échantillonnée.
